# FASCICULE DE BREVET EUROPEEN

(11) **EP 2 601 823 B1**
(45) Date de publication et mention de la délivrance du brevet: **13.06.2018**
(21) Numéro de dépôt: 11734156.0
(22) Date de dépôt: 22.07.2011
(51) Int. Cl.: H05K 3/30

(54) **PROCÉDÉ DE FABRICATION DE CARTES DE CIRCUIT IMPRIMÉ**
VERFAHREN ZUR HERSTELLUNG VON PLATINEN
PROCESS FOR FABRICATING PRINTED CIRCUIT BOARDS

(30) Priorité: 02.08.2010 FR 1056371
(43) Date de publication de la demande: 12.06.2013
(73) Titulaire: MAGNETI MARELLI FRANCE, 78190 Trappes (FR)
(72) Inventeur: FALLOURD, Ludovic, F-37320 Louans (FR)
(74) Mandataire: Regimbeau
(86) Numéro de dépôt international: PCT/EP2011/062675
(87) Numéro de publication internationale: WO 2012/016864

(56) Documents cités:
- JP-A- 8 078 837
- JP-A- 2008 166 377
- US-A- 5 155 904
- US-A1- 2007 175 969
- US-A1- 2009 134 529
- Burton S. Anderson: "Material Safety Data Sheet", , 19 avril 2006 (2006-04-19), XP007916235, Extrait de l'Internet: URL:http://www.multi-seals.com/msds.php [extrait le 2010-12-08]
- ANONYMOUS: "Simultaneous solder reflow and adhesive curing", RESEARCH DISCLOSURE, MASON PUBLICATIONS, HAMPSHIRE, GB, vol. 317, no. 40, 1 septembre 1990 (1990-09-01), XP007115528, ISSN: 0374-4353
- ANDERSON B: "Epoxy Resin Compounds", MATERIAL SAFETY DATA SHEET,, 19 April 2006 (2006-04-19), pages 1-6, XP007916235,

## Description

La présente invention concerne le domaine des circuits imprimés.

Dans le cadre de la présente invention l'expression « circuit imprimé » doit être comprise dans un sens large englobant tout support, carte électronique, circuit hybride, etc ..., quelle que soit sa nature, par exemple mais non limitativement résine époxy, fibres de verre, céramique, etc ..., muni de pistes électriquement conductrices propres à assurer une liaison électrique entre des composants, y compris les circuits imprimés flexibles.

Plus précisément la présente invention concerne le problème de la fixation mécanique de certains composants sur circuits imprimés.

L'homme de l'art sait qu'il est nécessaire de fixer mécaniquement certains composants sur circuit imprimé, notamment par exemple lorsque ces composants ont une masse importante, ou encore pour garantir leur fixation quand les circuits imprimés sont soumis à de fortes vibrations.

Une solution connue de l'état de la technique consiste à coller les composants sur la carte de circuit imprimé à l'aide d'une colle liquide.

La mise en oeuvre de cette technique ne donne cependant pas totalement satisfaction. Elle nécessite une mise en oeuvre spécifique avec des moyens spécifiques (personnel et/ou équipement).

Le document US 2007/175969 divulgue une autre technique de fixation de composant sur un circuit imprimé qui consiste à utiliser une colle comprenant un mélange de colle solide (thermosetting adhesive) et de particules de brasage (solder particles).

Dans ce contexte la présente invention a pour objectif de proposer de nouveaux moyens qui permettent de perfectionner l'état de la technique en termes de coût et de simplicité de mise en oeuvre, sans détériorer la fiabilité finale du produit.

L'objectif précité est atteint dans le cadre de la présente invention grâce à un procédé tel que défini en revendication 1 annexée.

Dans le cadre de la présente invention le terme « pastille » doit être compris dans un sens général englobant toute masse ou élément individuel de colle solide, quelle que soit sa géométrie. En particulier dans le cadre de la présente invention, le terme « pastille » n'est pas limité à un élément de forme cylindrique, mais englobe également un élément de contour parallélépipédique.

L'étape de durcissement est avantageusement une étape de polymérisation.

L'homme de l'art comprendra que la présente invention permet de simplifier notablement le processus de fabrication des cartes de circuit imprimé par rapport à l'état de la technique dans la mesure où elle permet d'éliminer complètement les étapes manuelles de dépôt de colle liquide ou encore la nécessité d'équipements complexe propres au dépôt d'une telle colle liquide.

Dans le cadre de la présente invention, la pastille de colle solide peut en effet être déposée à l'aide d'un équipement classique adapté pour le dépôt de composants, par exemple un équipement de dépôt de composants de type CMS (Composant Monté en Surface) grâce à un conditionnement des pastilles de colle solide adapté à ces équipements.

La présente invention concerne bien entendu également les cartes de circuit imprimé obtenues par la mise en oeuvre du procédé précité.

D'autres caractéristiques, buts et avantages de la présente invention apparaîtront à la lecture de la description détaillée qui va suivre et en regard des dessins annexés donnés à titre d'exemples non limitatifs et sur lesquels :
- les figures 1a, 1b et 1c représentent trois étapes principales d'un procédé conforme à un premier mode de mise en oeuvre de la présente invention,
- les figures 2a, 2b et 2c représentent trois étapes principales d'un procédé conforme à un deuxième mode de mise en oeuvre de la présente invention,
- les figures 3a, 3b, 3c, 3d et 3e représentent cinq étapes principales d'un procédé conforme à un troisième mode de mise en oeuvre de la présente invention, et
- la figure 4 représente une alternative du troisième mode de mise en oeuvre précité conforme à la présente invention.

Sur les figures annexées on a représenté en 10 une plaque de circuit imprimé, en 20 une couche de cuivre, en 30 une couche de vernis de protection, en 40 des zones de pâte à braser, en 50 des composants que l'on souhaite fixer mécaniquement par collage sur la plaque 10 et en 60 des pastilles de colle solide utilisées conformément à la présente invention.

On notera que les dessins annexés sont donnés à titre purement illustratif, les dimensions représentées ne respectant pas les échelles respectives réelles.

La plaque de circuit imprimé 10 peut être formée en tout matériau approprié, par exemple et non limitativement à partir de résine époxy ou de fibre de verre, et selon toute technique appropriée.

La couche de cuivre 20 peut revêtir un seul côté ou les deux côtés de la plaque 10. Elle est gravée selon tout procédé chimique approprié pour obtenir un ensemble de pistes adaptées pour la connexion des différents composants électroniques déposés sur la plaque 10 permettant d'obtenir le circuit électronique recherché.

La couche de vernis 30 est destinée à protéger les pistes de cuivre de l'oxydation et d'éventuels courts-circuits.

La liaison électriques entre les composants 50 et les pistes associées de la couche de cuivre 20 est assurée de façon connue en soi grâce à de la pâte à braser 40 ou tout matériau équivalent.

Il peut s'agir d'une technique de brasage par refusion consistant à enduire la plaque 10 d'une pâte à braser à travers un pochoir approprié aux emplacements des terminaisons des composants, à déposer les composants, puis à passer le circuit dans un four où la chaleur fait fondre la pâte déposée pour former une brasure assurant une liaison électrique entre les terminaisons des composants et les pistes en cuivre 20.

En variante il peut s'agir de toute technique équivalente à celle du brasage par refusion précitée.

La technique générale de réalisation de cartes de circuit imprimé à l'aide des moyens qui viennent d'être décrit est connue en soi et ne sera donc pas décrite plus en détail par la suite.

Dans le cadre de la présente invention, comme indiqué précédemment, il est prévu une étape de fixation mécanique de certains au moins des composants 50 qui met en oeuvre une pastille de colle solide 60.

La pastille de colle 60 est fondue, de sorte qu'elle vient mouiller le composant 50, et est polymérisée en contact avec le circuit imprimé 10 et le composant 50 afin de fixer mécaniquement le composant 50 sur le circuit imprimé 10, lors de l'étape classique de brasure du composant 50.

Plus précisément dans le cadre de la présente invention, comme indiqué précédemment, il est prévu avant de positionner la pastille de colle solide 60 sur la plaque 10 en position adjacente à l'emplacement du composant que l'on souhaite fixer mécaniquement par collage, de ménager sur le circuit imprimé 10 un moyen 100 de maintien provisoire de ladite pastille de colle solide 60.

La demanderesse a en effet déterminé qu'un tel moyen de maintien provisoire 100 est essentiel pour maintenir la pastille de colle solide 60 au contact du composant avant de procéder à l'étape de fusion et polymérisation de cette pastille 60. Sans un tel moyen de maintien provisoire 100, il existe un risque important de déplacement de ladite pastille de sorte que au final le composant n'est pas correctement fixé mécaniquement.

Le moyen de maintien provisoire 100 peut faire l'objet de différents modes de réalisation.

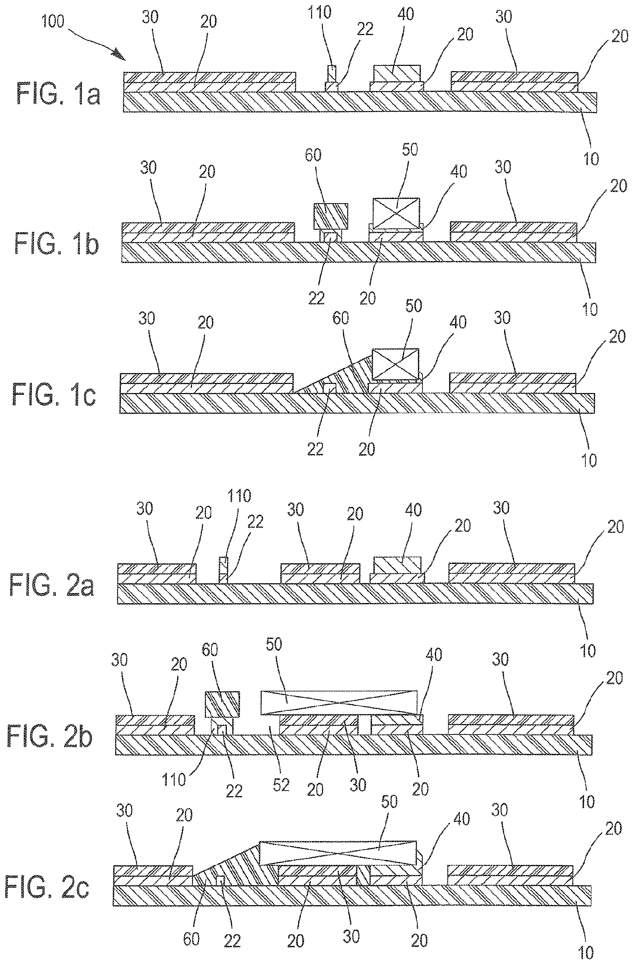

Selon le mode de réalisation représenté sur les figures 1a à 1c, le moyen de maintien provisoire 100 est formé d'un volume de pâte à braser 110 déposé sur un élément de cuivre 22 dépourvu de vernis 30, avant de recevoir la pastille de colle solide 60. L'élément de cuivre 22 étant dépourvu de vernis 30, il possède une épaisseur inférieure à celle des pistes de cuivre environnantes revêtues et forme ainsi une cuvette propre à maintenir la pastille de colle solide 60.

Une telle cuvette destinée à maintenir la pastille de colle solide 60 peut d'ailleurs être commune à plusieurs composants 50.

La cuvette précitée peut également être formée par d'autres moyens que ceux illustrés sur les dessins annexés, par exemple en déposant directement la pâte à braser 110 et la pastille de colle solide 60 sur le support 10, sans couche de cuivre 22 sous-jacente.

Selon le mode de réalisation représenté sur les figures 2a à 2c, le moyen de maintien provisoire 100 reprend un volume de pâte à braser 110 déposé sur un élément 22 de cuivre et destiné à recevoir une pastille de colle solide 60. Cependant selon les figures 2a à 2c, ce moyen de maintien provisoire est complété par le fait le composant 50 déborde de la piste de cuivre sous jacente 20 de sorte qu'il est formé sous le bord du composant 50 un espace ou canal libre 52 propre à recevoir la matière de colle 60 dès qu'un ramollissement suffisant est obtenu.

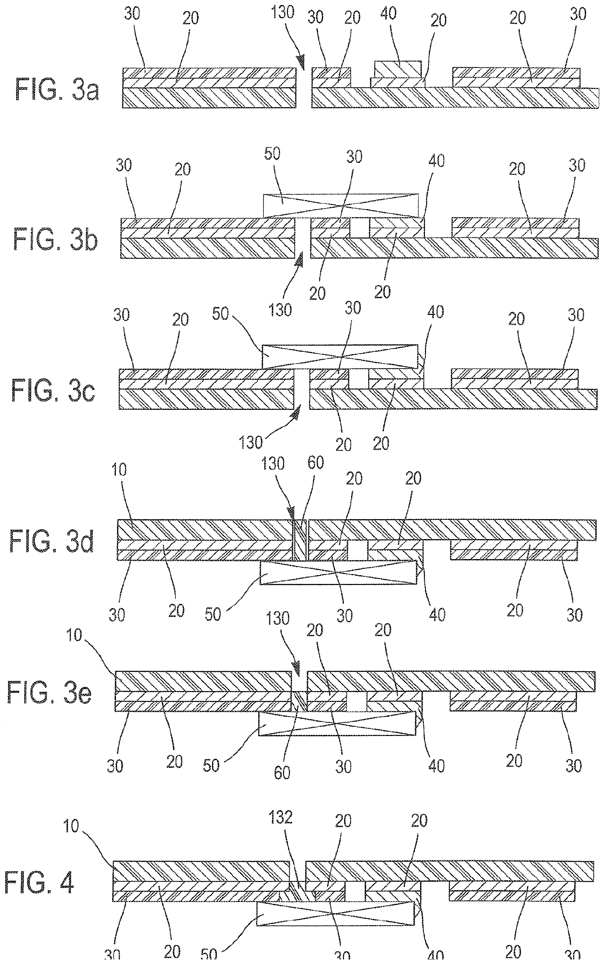

La variante de mise en oeuvre illustrée sur les figures 3a à 3e est adaptée au cas d'un processus de fabrication de carte de circuit imprimé comprenant deux étapes de brasage par refusion et retournement de la plaque de circuit imprimé entre ces deux étapes. Dans ce cas le moyen de maintien provisoire 100 est formé d'un orifice 130 traversant la plaquette 10 en regard ou à proximité du composant 50.

Les étapes illustrées sur les figures 3a à 3c sont classiques en soi pour la brasure d'un composant 50 sur des pistes 20 appropriées, par brasure par refusion ou encore brasure à la vague.

La carte est ensuite retournée comme on le voit à l'examen comparé des figures 3c et 3d. Puis une pastille de colle solide 60 est déposée dans l'orifice 130 ménagée préalablement en regard du composant 50. Lors d'une étape ultérieure de refusion, la pastille 60 est fondue. Elle adhère alors au composant 50 et durcit ou polymérise à son contact en assurant une fixation mécanique par collage entre le composant 50 et la carte 10.

On a représenté sur la figure 4 une variante selon laquelle l'orifice 130 destiné à recevoir la pastille de colle solide 60 possède une chambre évasée 132 au contact du composant 50. La présence de cette chambre évasée 132 permet d'améliorer d'une part le maintien et le confinement de la matière composant la pastille de colle 60 lors de la fusion de celle-ci et d'autre part la surface d'adhésion entre cette colle et le composant 50.

La demanderesse a déterminé qu'un matériau de colle solide particulièrement approprié pour la mise en oeuvre de la présente invention est une colle solide époxy, telle que la colle commercialisée par la société Multi Seal Inc, par exemple sous les références EPOXY DC-202, EPOXY DC-203 et EPOXY DC-204, notamment sous la référence EPOXY DC-203.

Une telle colle solide était jusqu'ici limitée dans son utilisation à l'étanchéité de composants.

De façon a priori surprenante la demanderesse a cependant déterminé que cette colle peut supporter sans difficulté les températures de refusion de brasure pour composants électroniques et qu'elle convient parfaitement pour une fixation mécanique de composants électroniques. Elle présente par ailleurs l'avantage de polymériser à une température inférieure à celle de fusion de la brasure de sorte qu'elle permet d'assurer, grâce à sa polymérisation, la fixation mécanique des composants 50 avant que la brasure ne soit effective.

Dans le cadre de la présente invention les pastilles de colle solide 60 sont de préférence déposée par une machine de dépôt automatique de composants, telle qu'une machine de dépôt de composants CMS. En variante les pastilles de colle solide 60 peuvent être déposées manuellement.

Dans le cadre de la présente invention, les composants 50 fixés mécaniquement par collage sont de préférence des composants électroniques. Cependant en variante, il peut s'agir de composants mécaniques.

Bien entendu la présente invention n'est pas limitée aux modes de réalisation particuliers qui viennent d'être décrits, mais s'étend à toutes variantes.

## Revendications

1. Procédé de fabrication de cartes de circuit imprimé comprenant les étapes qui consistent à :
• fournir un circuit imprimé (10, 20, 30) et au moins un composant (50) et
• fixer mécaniquement par collage le composant (50) sur le circuit imprimé (10, 20, 30),
l'étape de fixation mécanique consistant à
• fournir une pastille de colle solide (60),
• ménager sur le circuit imprimé un moyen (100) de maintien provisoire de ladite pastille de colle solide (60), adjacent à l'emplacement du composant (50) à fixer mécaniquement par collage,
• positionner la pastille de colle solide (60) sur le moyen de maintien provisoire (100), et
• fondre et durcir la pastille de colle solide (60) en contact avec le circuit imprimé (10) et le composant (50) afin de fixer mécaniquement le composant (50) sur le circuit imprimé (10), lors d'une étape de brasure du composant (50),
**caractérisé en ce que** ledit moyen (100) de maintien provisoire comprend un volume de pâte à braser (110), la pastille de colle solide a une température de polymérisation inférieure à la température de fusion de la pâte à braser et la pastille de colle solide (60) est positionnée sur le volume de pâte à braser (110).

2. Procédé selon la revendication 1, **caractérisé par le fait que** la pastille de colle solide (60) est une colle solide époxy.

3. Procédé selon l'une des revendications 1 ou 2, **caractérisé par le fait que** la pastille de colle solide (60) est une colle solide époxy dont la température de polymérisation est inférieure à la température de brasure.

4. Procédé selon l'une des revendications 1 à 3, **caractérisé par le fait que** le moyen de maintien provisoire (100) comprend une cuvette propre à maintenir la pastille de colle solide (60).

5. Procédé selon l'une des revendications 1 à 3, **caractérisé par le fait que** le moyen de maintien provisoire (100) comprend également un espace ou canal libre (52) sous le bord du composant (50), formé par débordement du composant (50) vis-à-vis de la piste de cuivre sous jacente (20).

6. Procédé selon l'une des revendications 1 à 5, **caractérisé par le fait que** la pastille de colle solide (60) est déposée par une machine de dépôt automatique de composants, telle qu'une machine de dépôt de composants CMS.

## Patentansprüche

1. Verfahren zur Herstellung von Leiterplatten, umfassend die Schritte, die bestehen im:
- Bereitstellen einer gedruckten Schaltung (10, 20, 30) und von mindestens einer Komponente (50), und
- mechanischen Befestigen durch Verkleben der Komponente (50) auf der gedruckten Schaltung (10, 20, 30),
wobei der Schritt des mechanischen Befestigens besteht im
- Bereitstellen eines festen Klebstoffpellets (60),
- Anfertigen, auf der gedruckten Schaltung, eines Mittels (100) zum provisorischen Halten des festen Klebstoffpellets (60) angrenzend zu der Stelle der Komponente (50), die mechanisch durch Verkleben befestigt werden soll,
- Positionieren des festen Klebstoffpellets (60) auf dem provisorischen Haltemittel (100), und
- Schmelzen und Härten des festen Klebstoffpellets (60) in Berührung mit der gedruckten Schaltung (10) und der Komponente (50), um die Komponente (50) bei einem Schritt des Lötens der Komponente (50) mechanisch auf der gedruckten Schaltung (10) zu befestigen,
**dadurch gekennzeichnet, dass** das provisorische Haltemittel (100) ein Lötpaste-Volumen (110) umfasst, das feste Klebstoffpellet eine Polymerisationstemperatur unterhalb der Schmelztemperatur der Lötpaste aufweist, und das feste Klebstoffpellet (60) auf dem Lötpaste-Volumen (110) positioniert ist.

2. Verfahren nach Anspruch 1, **dadurch gekennzeichnet, dass** das feste Klebstoffpellet (60) ein fester Epoxidklebstoff ist.

3. Verfahren nach einem der Ansprüche 1 oder 2, **dadurch gekennzeichnet, dass** das feste Klebstoffpellet (60) ein fester Epoxidklebstoff ist, dessen Polymerisationstemperatur unterhalb der Löttemperatur liegt.

4. Verfahren nach einem der Ansprüche 1 bis 3, **dadurch gekennzeichnet, dass** das provisorische Haltemittel (100) eine Küvette umfasst, die in der Lage ist, das feste Klebstoffpellet (60) zu halten.

5. Verfahren nach einem der Ansprüche 1 bis 3, **dadurch gekennzeichnet, dass** das provisorische Haltemittel (100) ebenfalls einen Freiraum oder -kanal (52) unter dem Rand der Komponente (50) umfasst, der durch Überstand der Komponente (50) gegenüber der darunterliegenden Kupferbahn (20) gebildet wird.

6. Verfahren nach einem der Ansprüche 1 bis 5, **dadurch gekennzeichnet, dass** das feste Klebstoffpellet (60) von einer automatischen Komponenten-Auftragsmaschine, wie etwa einer SMD-Komponenten-Auftragsmaschine aufgebracht wird.

## Claims

1. Process for fabricating printed circuit boards, which comprises the steps consisting of:
- providing a printed circuit (10, 20, 30) and at least one component (50) and
- mechanically fastening the component (50) to the printed circuit (10, 20, 30) by bonding,
the mechanical fastening step consisting of
- delivering a spot of solid adhesive (60),
- providing, on the printed circuit, a means (100) for the temporary retention of said spot of solid adhesive (60) adjacent to the location of the component (50) to be mechanically fastened by bonding,
- positioning the spot of solid adhesive (60) on the temporary retention means (100), and
- melting and curing the spot of solid adhesive (60) in contact with the printed circuit (10) and with the component (50) in order for the component (50) to be mechanically fastened to the printed circuit (10) in a step of soldering the component (50),
**characterised in that** said temporary retention means (100) comprises a volume of solder paste (110), the spot of solid adhesive has a polymerisation temperature that is lower than the melting temperature of the solder paste and the spot of solid adhesive (60) is positioned on the volume of solder paste (110).

2. Process according to claim 1, **characterised in that** the spot of solid adhesive (60) is a solid epoxy adhesive.

3. Process according to either claim 1 or claim 2, **characterised in that** the spot of solid adhesive (60) is a solid epoxy adhesive, the polymerisation temperature whereof is lower than the soldering temperature.

4. Process according to one of claims 1 to 3, **characterised in that** the temporary retention means (100) comprises a trough designed to retain the spot of solid adhesive (60).

5. Process according to one of claims 1 to 3, **characterised in that** the temporary retention means (100) further comprises a space or free channel (52) beneath the edge of the component (50), formed by the overlay of the component (50) relative to the underlying copper track (20).

6. Process according to one of claims 1 to 5, **characterised in that** the spot of solid adhesive (60) is deposited by an automated component deposition machine, such as a surface-mounted component deposition machine.
